(19) **Europäisches Patentamt European Patent Office Office européen des brevets**

(11) **EP 4 550 960 A1**

(12) **EUROPEAN PATENT APPLICATION**
published in accordance with Art. 153(4) EPC

(43) Date of publication:
07.05.2025 Bulletin 2025/19

(21) Application number: 23831331.6

(22) Date of filing: 26.06.2023

(51) International Patent Classification (IPC):
H05K 9/00 (2006.01)       B32B 7/027 (2019.01)
B32B 15/08 (2006.01)      B32B 15/20 (2006.01)
B32B 27/18 (2006.01)      B32B 27/40 (2006.01)
H01B 5/14 (2006.01)       H01F 1/26 (2006.01)

(52) Cooperative Patent Classification (CPC):
B32B 7/027; B32B 15/08; B32B 15/20;
B32B 27/18; B32B 27/40; H01B 5/14; H01F 1/26;
H05K 9/00

(86) International application number:
PCT/JP2023/023447

(87) International publication number:
WO 2024/004889 (04.01.2024 Gazette 2024/01)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: 29.06.2022 JP 2022104532
07.09.2022 JP 2022142005

(71) Applicant: **FUJIFILM Corporation**
**Tokyo 106-8620 (JP)**

(72) Inventors:
• **FUKAGAWA Kiyotaka**
  **Minamiashigara-shi, Kanagawa 250-0193 (JP)**
• **MIKAMI Tatsuo**
  **Minamiashigara-shi, Kanagawa 250-0193 (JP)**

(74) Representative: **Klunker IP**
**Patentanwälte PartG mbB**
**Destouchesstraße 68**
**80796 München (DE)**

(54) **ELECTROMAGNETIC WAVE SHIELDING MATERIAL, ELECTRONIC COMPONENT AND ELECTRONIC DEVICE**

(57)     Provided are an electromagnetic wave shielding material including a magnetic layer containing magnetic particles and a resin, between two metal layers, in which the magnetic layer is in direct contact with each of the two metal layers, and the magnetic layer contains 13 parts by mass or more and less than 30 parts by mass of a urethane bond-containing resin with respect to 100 parts by mass of a total mass of the magnetic layer, and an electronic component and an electronic apparatus including the electromagnetic wave shielding material.

**EP 4 550 960 A1**

**Description**

[Technical Field]

The present invention relates to an electromagnetic wave shielding material, an electronic component, and an electronic apparatus.

[Background Art]

PTL 1 discloses a noise suppression sheet comprising a sheet-shaped composite magnetic material.

[Citation List]

[Patent Literature]

[PTL1] JP2019-153623A

[Summary of Invention]

[Technical Problem]

In recent years, an electromagnetic wave shielding material has attracted attention as a material for reducing the influence of an electromagnetic wave in various electronic components and various electronic apparatuses. An electromagnetic wave shielding material (hereinafter, also described as a "shielding material") is capable of exhibiting the performance of shielding electromagnetic waves (hereinafter, also referred to as an "electromagnetic wave shielding ability" or a "shielding ability") by reflecting electromagnetic waves incident on the shielding material by the shielding material and/or by attenuating the electromagnetic waves in the inside the shielding material. For example, the noise suppression sheet described in JP2019-153623A can function as an electromagnetic wave shielding material.

It is desired that the electromagnetic wave shielding material can exhibit a high shielding ability. The electromagnetic wave shielding material that exhibits a high shielding ability against electromagnetic waves can contribute to a significant reduction in the influence of electromagnetic waves in electronic components and electronic apparatuses.

In addition, a force may be applied from the outside to the electromagnetic wave shielding material for forming, and even after the electromagnetic wave shielding material is molded and incorporated into an electronic component or an electronic apparatus, a force may be applied from the outside due to, for example, falling or collision. The durability to withstand such an external force can also be shown as an example, as a desired performance of the electromagnetic wave shielding material.

In view of the above circumstances, an object of an aspect of the present invention is to provide an electromagnetic wave shielding material which can exhibit high shielding ability and has excellent durability.

[Solution to Problem]

An aspect of the present invention is as follows.

[1] An electromagnetic wave shielding material comprising:

a magnetic layer containing magnetic particles and a resin, between two metal layers,
in which the magnetic layer is in direct contact with each of the two metal layers, and
the magnetic layer contains 13 parts by mass or more and less than 30 parts by mass of a urethane bond-containing resin with respect to 100 parts by mass of a total mass of the magnetic layer.

[2] The electromagnetic wave shielding material according to [1],
in which the magnetic layer contains 15 parts by mass or more and 23 parts by mass or less of a urethane bond-containing resin with respect to 100 parts by mass of the total mass of the magnetic layer.
[3] The electromagnetic wave shielding material according to [2],
in which a glass transition temperature of the urethane bond-containing resin is -60°C or higher and lower than 0°C.
[4] The electromagnetic wave shielding material according to any one of [1] to [3],
in which the magnetic layer further contains an epoxy resin.
[5] The electromagnetic wave shielding material according to [4]

in which a total content of the urethane bond-containing resin and an epoxy resin in the magnetic layer is 15 parts by mass or more and 20 parts by mass or less with respect to 100 parts by mass of the total mass of the magnetic layer.

[6] The electromagnetic wave shielding material according to any one of [1] to [5],

in which two or more multilayer structures in which the magnetic layer is provided between the two metal layers are included, and
the magnetic layer is in direct contact with each of the two metal layers in each multilayer structure.

[7] The electromagnetic wave shielding material according to any one of [1] to [6],
in which one or more of the metal layers are metal layers having a Cu content rate of 80.0% by mass or more.

[8] The electromagnetic wave shielding material according to any one of [1] to [7],
in which one or more of the metal layers are metal layers having an Al content rate of 80.0% by mass or more.

[9] The electromagnetic wave shielding material according to [1],

in which the magnetic layer contains 15 parts by mass or more and 23 parts by mass or less of a urethane bond-containing resin with respect to 100 parts by mass of the total mass of the magnetic layer,
a glass transition temperature of the urethane bond-containing resin is -60°C or higher and lower than 0°C,
the electromagnetic wave shielding material includes two or more multilayer structures in which the magnetic layer is provided between the two metal layers, and the magnetic layer is in direct contact with each of the two metal layers in each multilayer structure, and
one or more metal layers are metal layers having a Cu content rate of 80.0% by mass or more.

[10] The electromagnetic wave shielding material according to [1],

in which the magnetic layer contains 15 parts by mass or more and 23 parts by mass or less of a urethane bond-containing resin with respect to 100 parts by mass of the total mass of the magnetic layer,
a glass transition temperature of the urethane bond-containing resin is -60°C or higher and lower than 0°C,
the electromagnetic wave shielding material includes two or more multilayer structures in which the magnetic layer is provided between the two metal layers, and the magnetic layer is in direct contact with each of the two metal layers in each multilayer structure, and
one or more metal layers are metal layers having an Al content rate of 80.0% by mass or more.

[11] The electromagnetic wave shielding material according to [1],

in which the magnetic layer further contains an epoxy resin,
a total content of the urethane bond-containing resin and the epoxy resin in the magnetic layer is 15 parts by mass or more and 20 parts by mass or less with respect to 100 parts by mass of the total mass of the magnetic layer,
a glass transition temperature of the urethane bond-containing resin is -60°C or higher and lower than 0°C,
the electromagnetic wave shielding material includes two or more multilayer structures in which the magnetic layer is provided between the two metal layers, and the magnetic layer is in direct contact with each of the two metal layers in each multilayer structure, and
one or more of the metal layers are metal layers having a Cu content rate of 80.0% by mass or more.

[12] An electronic component comprising:
the electromagnetic wave shielding material according to any one of [1] to [11].

[13] An electronic apparatus comprising:
the electromagnetic wave shielding material according to any one of [1] to [11].

[Effects of Invention]

According to one aspect of the present invention, it is possible to provide an electromagnetic wave shielding material that is capable of exhibiting a high shielding ability and is excellent in durability. In addition, according to one aspect of the present invention, it is possible to provide an electronic component and an electronic apparatus, which include the electromagnetic wave shielding material.

[Brief description of Drawings]

[Fig. 1] Fig. 1 is an explanatory view of a measurement of peel strength.
[Fig. 2] Fig. 2 is an explanatory view of the measurement of the peel strength.

[Description of Embodiments]

[Electromagnetic wave shielding material]

An aspect of the present invention relates to an electromagnetic wave shielding material including a magnetic layer containing magnetic particles and a resin, between two metal layers, in which the magnetic layer is in direct contact with each of the two metal layers, and the magnetic layer contains 13 parts by mass or more and less than 30 parts by mass of a urethane bond-containing resin with respect to 100 parts by mass of a total mass of the magnetic layer.

In the present invention and the present specification, the "electromagnetic wave shielding material" shall refer to a material that is capable of exhibiting shielding ability against an electromagnetic wave of at least one frequency or at least a part of a range of a frequency band. The "electromagnetic wave" includes a magnetic field wave and an electric field wave. The "electromagnetic wave shielding material" is preferably a material that is capable of exhibiting shielding ability against one or both of a magnetic field wave of at least one frequency or at least a part of a range of a frequency band and an electric field wave of at least one frequency or at least a part of a range of a frequency band.

In the present invention and the present specification, "magnetic" means having a ferromagnetic property. Details of the magnetic layer will be described later.

In the present invention and the present specification, the "metal layer" shall refer to a layer containing a metal. The metal layer can be a layer containing one or more kinds of metals as a pure metal consisting of a single metal element, as an alloy of two or more kinds of metal elements, or as an alloy of one or more kinds of metal elements and one or more kinds of non-metal elements. Details of the metal layer will be described later.

In the present invention and the present specification, the term "in direct contact" of the magnetic layer and the metal layer means that the magnetic layer and the metal layer are disposed to be directly adjacent to each other without interposing another layer.

Regarding the electromagnetic wave shielding material, the inventors of the present invention presume that the reason why the electromagnetic wave shielding material is capable of exhibiting a high shielding ability against electromagnetic waves is due to the fact that the electromagnetic wave shielding material has a multilayer structure in which a magnetic layer is sandwiched between two metal layers. The details are as follows. In order to obtain a high shielding ability against electromagnetic waves in the electromagnetic wave shielding material, it is desirable to increase the reflection at the interface in addition to increasing the ability to attenuate electromagnetic waves. That is, it is desirable that the electromagnetic wave repeatedly reflects at the interface and passes through the shielding material a large number of times to be largely attenuated. However, as the behavior of the metal layer and the magnetic layer with respect to the electromagnetic wave, the reflection of the magnetic field wave at the interface tends to be small although the metal layer has a large ability to attenuate the electromagnetic wave, and the reflection of the magnetic field wave at the interface tends to be larger than that in the metal layer although the magnetic layer has a smaller ability to attenuate the electromagnetic wave than the metal layer. Therefore, with the metal layer alone or the magnetic layer alone, it is difficult to achieve both high reflection and high attenuation of, particularly, the magnetic field wave among the electromagnetic waves. On the other hand, due to including a multilayer structure having the magnetic layer between two metal layers, the electromagnetic wave shielding material makes it possible to achieve both the above-described reflection at the interface and the above-described attenuation within the layer. The inventors of the present invention conceive this fact is the reason why the electromagnetic wave shielding material is capable of exhibiting a high shielding ability against magnetic field waves. However, the present invention is not limited to the presumption described in the present specification.

Furthermore, in the above-described multilayer structure, the magnetic layer in direct contact with each of the two metal layers contains 13 parts by mass or more and less than 30 parts by mass of a urethane bond-containing resin with respect to 100 parts by mass of the total mass of the magnetic layer. The inventors of the present invention consider that this contributes to the fact that the electromagnetic wave shielding material can exhibit a high shielding ability and can exhibit excellent durability. This point will be described below in detail.

Hereinafter, the electromagnetic wave shielding material will be described in more detail.

<Magnetic layer>

The magnetic layer contains magnetic particles and a resin.

(Magnetic particle)

As the magnetic particle, one kind selected from the group consisting of magnetic particles generally called soft magnetic particles, such as metal particles and ferrite particles, can be used, or two or more kinds therefrom can be used in combination. Since the metal particles generally have a saturation magnetic flux density of about 2 to 3 times as compared with ferrite particles, the metal particles can maintain specific magnetic permeability and exhibit shielding ability even under a strong magnetic field without magnetic saturation. Therefore, the magnetic particles to be contained in the magnetic layer are preferably metal particles. In the present invention and the present specification, a layer containing metal particles as the magnetic particles shall correspond to the "magnetic layer".

Metal particle

Examples of the metal particles as the magnetic particles include particles of Sendust (a Fe-Si-Al alloy), permalloy (a Fe-Ni alloy), molybdenum permalloy (a Fe-Ni-Mo alloy), a Fe-Si alloy, a Fe-Cr alloy, a Fe-containing alloy generally called the iron-based amorphous alloy, a Co-containing alloys generally called the cobalt-based amorphous alloy, an alloy generally called the nanocrystal alloy, iron, Permendur (a Fe-Co alloy). Among them, Sendust is preferable since it exhibits a high saturation magnetic flux density and a high specific magnetic permeability. The metal particle may contain, in addition to the constitutional element of the metal (including the alloy), elements contained in an additive that can be optionally added and/or elements contained in impurities that can be unintentionally mixed in a manufacturing process of the metal particle at any content rate. In the metal particle, the content rate of the constitutional element of the metal (including the alloy) is preferably 90.0% by mass or more and more preferably 95.0% by mass or more, and it may be 100% by mass or may be less than 100% by mass, 99.9% by mass or less, or 99.0% by mass or less.

In one form, the shielding ability of the electromagnetic wave shielding material against the electromagnetic wave can be evaluated using, as an indicator, the magnetic permeability (specifically, the real part of the complex specific magnetic permeability) of the magnetic layer included in the electromagnetic wave shielding material. The electromagnetic wave shielding material including a magnetic layer exhibiting a high magnetic permeability (specifically, a real part of a complex specific magnetic permeability) is preferable since a high shielding ability can be exhibited against electromagnetic waves.

In a case where a complex specific magnetic permeability is measured by a magnetic permeability measuring apparatus, a real part $\mu'$ and an imaginary part $\mu'$ are generally displayed. In the present invention and the present specification, a real part of a complex specific magnetic permeability shall refer to such a real part $\mu'$. Hereinafter, a real part of a complex specific magnetic permeability at a frequency of 3 megahertz (MHz) is also simply referred to as "magnetic permeability" or "magnetic permeability $\mu'$". The magnetic permeability can be measured by a commercially available magnetic permeability measuring apparatus or a magnetic permeability measuring apparatus having a known configuration. The measurement temperature is set to 25°C. By setting an atmosphere temperature around the measurement sample to the measurement temperature, the temperature of the measurement sample can be set to the measurement temperature by establishing a temperature equilibrium. From the viewpoint that still more excellent electromagnetic wave shielding ability can be exhibited, the magnetic permeability (the real part of complex specific magnetic permeability at a frequency of 3 MHz) of the magnetic layer included in the electromagnetic wave shielding material is preferably 40 or more, more preferably 100 or more, and still more preferably 120 or more. In addition, the magnetic permeability can be, for example, 500 or less, 300 or less, or 200 or less, and it can exceed the values exemplified here. The electromagnetic wave shielding material having a high magnetic permeability is preferable since it can exhibit an excellent electromagnetic wave shielding ability.

From the viewpoint of forming a magnetic layer that exhibits a high magnetic permeability, the above-described magnetic particles are preferably particles having a flat shape (flat-shaped particles), and more preferably metal particles having a flat shape. In a case of arranging the long side direction of the flat-shaped particles to be closer to a state parallel to the in-plane direction of the magnetic layer, the magnetic layer can exhibit a higher magnetic permeability since the diamagnetic field can be reduced by aligning the long side direction of the particle with the vibration direction of the electromagnetic wave incident orthogonal to the electromagnetic wave shielding material. In the present invention and the present specification, the "flat-shaped particle" refers to a particle having an aspect ratio of 0.20 or less. The aspect ratio of the flat-shaped particles is preferably 0.15 or less, and more preferably 0.10 or less. The aspect ratio of the flat-shaped particles can be, for example, 0.01 or more, 0.02 or more, or 0.03 or more. It is possible to make the shape of the particle flat-shaped, for example, by carrying out the flattening process according to a known method. For the flattening process, for example, the description of JP2018-131640A can be referenced, and for example, the description of paragraphs 0016 and 0017 and the description of Examples of the same publication can be referenced. Examples of the magnetic layer that exhibits a high magnetic permeability include a magnetic layer containing flat-shaped particles of Sendust.

As described above, from the viewpoint of forming a layer that exhibits a high magnetic permeability as the magnetic layer, it is preferable to arrange the long side direction of the flat-shaped particles to be closer to a state parallel to the in-plane direction of the magnetic layer. From this point, the alignment degree which is a sum of an absolute value of the average value of alignment angles of the flat-shaped particles with respect to the surface of the magnetic layer and a variance of the alignment angles is preferably 30° or lower, more preferably 25° or lower, still more preferably 20° or lower, and even still more preferably 15° or lower. The alignment degree can be, for example, 3° or higher, 5° or higher, or 10° or higher, and it can be lower than the values exemplified here. A method of controlling the alignment degree will be described later.

In the present invention and the present specification, the aspect ratio of the magnetic particle and the alignment degree are determined according to the following methods.

A cross section of a magnetic layer is exposed according to a known method. In a randomly selected region of this cross section, a cross-sectional image is acquired as a scanning electron microscope (SEM) image. The imaging conditions are set to be an acceleration voltage of 2 kV and a magnification of 1,000 times, and an SEM image is obtained as the backscattered electron image.

Reading is carried out in grayscale with the cv2.imread () function of Image processing library OpenCV 4 (manufactured by Intel Corporation) by setting the second argument to 0, and a binarized image is obtained with the cv2.threshold () function, using an intermediate brightness between the high-brightness portion and the low-brightness portion as a boundary. A white portion (high-brightness portion) in the binarized image is defined as a magnetic particle.

Regarding the obtained binarized image, a rotational circumscribed rectangular shape corresponding to a portion of each magnetic particle is determined according to the cv2.minAreaRect () function, and the long side length, the short side length, and the rotation angle are determined as the return values of the cv2.minAreaRect () function. In a case of determining the total number of magnetic particles included in the binarized image, it shall be assumed that particles in which only a part of the particle is included in the binarized image are also included. Regarding the particles in which only a part of the particle is included in the binarized image, the long side length, the short side length, and the rotation angle of the portion included in the binarized image are determined. The ratio of the short side length to the long side length (short side length/long side length) determined in this way shall be denoted as the aspect ratio of each magnetic particle. In the present invention and the present specification, in a case where the number of magnetic particles which have an aspect ratio of 0.20 or less and are defined as flat-shaped particles is 10% or more on a number basis with respect to the total number of magnetic particles included in the binarized image, it shall be determined that the magnetic layer is a "magnetic layer including flat-shaped particles as the magnetic particles". In addition, from the rotation angle determined as above, an "alignment angle" is determined as a rotation angle with respect to a horizontal plane (the surface of the magnetic layer).

Particles having an aspect ratio of 0.20 or less, which are determined in the binarized image, are defined as flat-shaped particles. Regarding the alignment angles of all the flat-shaped particles included in the binarized image, the sum of the absolute value of the average value (arithmetic average) and the variance is determined. The sum determined in this way is referred to as the "alignment degree". It is noted that the coordinates of the circumscribed rectangle are calculated using the cv2.boxPoints () function, and an image in which the rotational circumscribed rectangle is superposed on the original image is created according to the cv2.drawContours () function, where a rotational circumscribed rectangle that is erroneously detected clearly is excluded from the calculation of the aspect ratio and the alignment degree. In addition, an average value (arithmetic average) of the aspect ratios of the particles defined as the flat-shaped particles shall be denoted as the aspect ratio of the flat-shaped particles to be contained in a magnetic layer to be measured. Such an aspect ratio is 0.20 or less, preferably 0.15 or less, and more preferably 0.10 or less. In addition, the aspect ratio can be, for example, 0.01 or more, 0.02 or more, or 0.03 or more.

The content of the magnetic particles in the magnetic layer can be, for example, 50 parts by mass or more, 60 parts by mass or more, 70 parts by mass or more, or 80 parts by mass or more, and can be, for example, 87 parts by mass or less, 85 parts by mass or less, 80 parts by mass or less, or 75 parts by mass or less, with respect to 100 parts by mass of the total mass of the magnetic layer. The magnetic layer can contain only one kind of magnetic particles, or can contain two or more kinds of magnetic particles at any ratio. In the present invention and the present specification, in a case where two or more kinds of components are contained, the content refers to a total content of the components. The contents of various components in the magnetic layer can be determined by a well-known method such as thermogravimetry/differential thermal analysis (TG/DTA) or extraction of various components using a solvent. It is noted that "TG/DTA" is generally called thermal gravity-differential thermal analysis. In a case where a composition of a composition for forming a magnetic layer, which has been used for forming the magnetic layer, is known, the contents of various components in the magnetic layer can be also determined from this known composition.

In one form, the magnetic layer can be a layer having insulating properties. In the present invention and the present specification, the "insulating properties" means that the electrical conductivity is smaller than 1 siemens (S)/m. The electrical conductivity of a certain layer is calculated according to the following expression from the surface electrical resistivity of the layer and the thickness of the layer. The electrical conductivity can be measured by a known method.

$$\text{Electrical conductivity [S/m]} = 1/(\text{surface electrical resistivity [}\Omega\text{]} \times \text{thickness [m]})$$

The inventors of the present invention presume that it is preferable that the magnetic layer is a layer having insulating properties in order for the electromagnetic wave shielding material to exhibit a higher electromagnetic wave shielding ability. From this point, the electrical conductivity of the magnetic layer is preferably smaller than 1 S/m, more preferably 0.5 S/m or less, still more preferably 0.1 S/m or less, and even still more preferably 0.05 S/m or less. The electrical conductivity of the magnetic layer can be, for example, $1.0 \times 10^{-12}$ S/m or more or $1.0 \times 10^{-10}$ S/m or more.

(Resin)

The magnetic layer is a layer containing magnetic particles and a resin. The resin can act as a binder in the magnetic layer. In the present invention and the present specification, a layer containing both magnetic particles and a resin shall correspond to the "magnetic layer". In the present invention and the present specification, the "resin" means a polymer, and it shall include rubber and an elastomer as well. The polymer includes a homopolymer and a copolymer. The rubber includes natural rubber and synthetic rubber. The elastomer is a polymer that exhibits elastic deformation.

Urethane bond-containing resin

The magnetic layer contains a urethane bond-containing resin. In the present invention and the present specification, the "urethane bond-containing resin" refers to a resin containing one or more urethane bonds (-NH-C(=O)O-) in one molecule. The urethane bond-containing resin includes various urethane bond-containing resins such as a polyurethane resin, a polyester urethane resin, and a polyurethane-based elastomer. In the magnetic layer, the polyurethane resin may be used alone or in combination of two or more kinds thereof. It is noted that the kind of the resin contained in the magnetic layer can be determined by, for example, organic analysis such as thermal decomposition gas chromatography/mass spectrometry (GC/MS) or Fourier transform infrared spectroscopy. For example, in a case where an isocyanate component residue and/or a polyol component residue has been observed in thermal decomposition GC/MS, it can be determined that the resin is a urethane bond-containing resin.

From the viewpoint of enhancing the adhesiveness between the magnetic layer and the metal layer in direct contact with the magnetic layer, the content of the urethane bond-containing resin in the magnetic layer is 13 parts by mass or more, preferably 14 parts by mass or more, more preferably 15 parts by mass or more, still more preferably 16 parts by mass or more, and even still more preferably 17 parts by mass or more, with respect to 100 parts by mass of the total mass of the magnetic layer. In a case where the adhesiveness between the metal layer in direct contact with the magnetic layer is high, peeling between the magnetic layer and the metal layer is less likely to occur in a case where a force is applied to the electromagnetic wave shielding material from the outside. It is preferable that such occurrence of peeling can be suppressed since this leads to improvement of the durability of the electromagnetic wave shielding material. In addition, from the viewpoint of improving the shielding ability of the electromagnetic wave shielding material, the content of the urethane bond-containing resin in the magnetic layer is less than 30 parts by mass, preferably 29 parts by mass or less, and more preferably 28 parts by mass or less, 27 parts by mass or less, 26 parts by mass or less, 25 parts by mass or less, 24 parts by mass or less, and 23 parts by mass or less in this order, with respect to 100 parts by mass of the total mass of the magnetic layer.

The electromagnetic wave shielding material can be used, for example, by being bent into any shape. In a case where the magnetic layer breaks in a case where the shielding material is bent, the shielding ability may deteriorate at the broken place. Therefore, a magnetic layer, which has excellent breakage resistance and is difficult to break during bending, is desirable. From the viewpoint of improving the breakage resistance of the magnetic layer, the magnetic layer is preferably a layer containing a urethane bond-containing resin having a glass transition temperature Tg of less than 0°C. In the present invention and the present specification, the glass transition temperature Tg is determined as the baseline shift start temperature of a heat flow chart at the time of temperature rise from the measurement result of the heat flow measurement using a differential scanning calorimeter. From the viewpoint of further improving the breakage resistance of the magnetic layer, the glass transition temperature Tg of the urethane bond-containing resin contained in the magnetic layer is more preferably -3°C or lower, still more preferably -5°C or lower, and even more preferably -10°C or lower, -20°C or lower, -30°C or lower, and -40°C or lower in this order. In addition, the glass transition temperature Tg of the resin contained in the magnetic layer can be, for example, -100°C or higher, -90°C or higher, -80°C or higher, -70°C or higher, or -60°C or higher.

The resin contained in the magnetic layer can be only a urethane bond-containing resin, or one or more other resins may be contained in a random amount in addition to the urethane bond-containing resin. The content of the urethane bond-containing resin with respect to 100 parts by mass of the total amount of the resin of the magnetic layer can be, for example, 80 parts by mass or more, 85 parts by mass or more, 90 parts by mass or more, or 95 parts by mass or more, and can also be 100 parts by mass, 100 parts by mass or less, less than 100 parts by mass, 99 parts by mass or less, or 98 parts by mass or less.

Epoxy resin

The magnetic layer can also contain an epoxy resin in addition to the urethane bond-containing resin. In the present invention and the present specification, the "epoxy resin" refers to a resin containing one or more epoxy groups in one molecule. In the magnetic layer containing an epoxy resin, at least a part of the epoxy groups contained in the epoxy resin may be in a ring-opened form. As the epoxy resin, a known epoxy resin such as a glycidyl ether type, a glycidyl ester type, a glycidylamine type, or an oxidative type may be used alone, or two or more types thereof may be used in combination. Examples of the glycidyl ether type include a Bis-A type epoxy resin, a Bis-F type epoxy resin, a High-Br type epoxy resin, a novolac type epoxy resin, and an alcohol type epoxy resin. Examples of the glycidyl ester type include a hydrophthalic acid type epoxy resin and a dimer acid type epoxy resin. Examples of the glycidylamine type include an aromatic amine type epoxy resin and an aminophenol type epoxy resin. Examples of the oxidized type include an alicyclic epoxy resin. From the viewpoint of imparting flexibility to the electromagnetic wave shielding material, the epoxy resin is preferably a glycidyl ether type Bis-A type epoxy resin having a hydrocarbon chain. The hydrocarbon chain is preferably an aliphatic hydrocarbon chain, and more preferably an aliphatic hydrocarbon chain having an alkylene chain length of 3 or more. Specific examples of the glycidyl ether type Bis-A type epoxy resin having an aliphatic hydrocarbon chain having an alkylene chain length of 3 or more include HP-A-4860 manufactured by DIC Corporation.

In a case where the magnetic layer contains an epoxy resin, the content of the epoxy resin in the magnetic layer is more than 0 parts by mass, and can also be 1 part by mass or more, and from the viewpoint of the self-supporting property of the magnetic layer, it is preferably 10 parts by mass or less, more preferably 8 parts by mass or less, and still more preferably 6 parts by mass or less, with respect to 100 parts by mass of the total mass of the magnetic layer. In addition, the total content of the urethane bond-containing resin and the epoxy group-containing resin in the magnetic layer is preferably 15 parts by mass or more from the viewpoint of improving the adhesiveness between the magnetic layer and the metal layer in direct contact with the magnetic layer, and preferably 20 parts by mass or less from the viewpoint of improving the shielding ability of the electromagnetic wave shielding material, with respect to 100 parts by mass of the total mass of the magnetic layer.

In addition to the above-described components, the magnetic layer can also contain any amount of one or more known additives such as a curing agent, a curing catalyst, a dispersing agent, a stabilizer, and a coupling agent.

Examples of the curing agent include a compound having a crosslinkable group. In a case where the curing agent is a compound having a crosslinkable group, in the magnetic layer containing such a curing agent, the curing agent can be contained in a form in which at least a part of the crosslinkable groups have already undergone a crosslinking reaction. In the present invention and the present specification, the "crosslinkable group" refers to a group capable of undergoing a crosslinking reaction, and specific examples thereof include an isocyanate group. The curing agent is preferably a compound having two or more (for example, two or more and four or less) crosslinkable groups in one molecule, and specific examples thereof include polyfunctional isocyanate. The polyfunctional isocyanate is a compound having two or more isocyanate groups in one molecule, and can be, for example, a compound having two or more and four or less isocyanate groups in one molecule. In one form, the magnetic layer can contain 2.5 parts by mass or more or 10 parts by mass or more of the polyfunctional isocyanate, with the resin contained in the magnetic layer being 100 parts by mass. In addition, in one form, the magnetic layer can contain 100 parts by mass or less or 40 parts by mass or less of the polyfunctional isocyanate, with the resin contained in the magnetic layer being 100 parts by mass. In addition, in one form, the magnetic layer can contain 2.5 parts by mass or more or 10 parts by mass or more of the polyfunctional isocyanate, with the urethane bond-containing resin contained in the magnetic layer being 100 parts by mass. In addition, in one form, the magnetic layer can contain 100 parts by mass or less or 40 parts by mass or less of the polyfunctional isocyanate, with the urethane bond-containing resin contained in the magnetic layer being 100 parts by mass.

<Metal layer>

The electromagnetic wave shielding material has a multilayer structure including the magnetic layer between two metal layers. In the multilayer structure, the magnetic layer is a layer in direct contact with each of the two metal layers. The electromagnetic wave shielding material includes one or more such multilayer structures and can also include two or more such multilayer structures. That is, the electromagnetic wave shielding material includes at least two metal layers and can also include three or more metal layers. The two or three or more metal layers included in the electromagnetic wave shielding material have the same composition and thickness in one form and differ in composition and/or thickness in another form. In addition, in a case where the electromagnetic wave shielding material includes two or more layers of the magnetic layer, the two or more magnetic layers have the same composition and thickness in one form and differ in composition and/or thickness in another form. Specific examples of the layer configuration of the electromagnetic wave shielding material will be described later.

As the metal layer, a layer containing one or more kinds of metals selected from the group consisting of various pure metals and various alloys can be used. The metal layer can exhibit an attenuation effect in the shielding material.

Since the attenuation effect increases as the propagation constant increases and the propagation constant increases as the electrical conductivity increases, it is preferable that the metal layer contains a metal element having a high electrical conductivity. From this point, it is preferable that the metal layer contains a pure metal of Ag, Cu, Au, or Al, or an alloy containing any one of these as a main component. The pure metal is a metal consisting of a single metal element and may contain a trace amount of impurities. In general, a metal having a purity of 99.0% or more consisting of a single metal element is called a pure metal. The purity is based on mass. The alloy is generally prepared by adding one or more kinds of metal elements or non-metal elements to a pure metal to adjust the composition, for example, in order to prevent corrosion or improve the hardness. The main component in the alloy is a component having the highest ratio on a mass basis, and it can be, for example, a component that occupies 80.0% by mass or more (for example, less than 100% by mass or 99.8% by mass or less) in the alloy. From the viewpoint of economic efficiency, the alloy is preferably an alloy of a pure metal of Cu or Al or an alloy containing Cu or Al as a main component, and from the viewpoint of high electrical conductivity, it is preferably an alloy of a pure metal of Cu or an alloy containing Cu as a main component.

The purity of the metal in the metal layer, that is, the content rate of the metal can be 99.0% by mass or more, where it is preferably 99.5% by mass or more, and more preferably 99.8% by mass or more with respect to the total mass of the metal layer. Unless otherwise specified, the content rate of metal in the metal layer shall refer to the content rate on a mass basis. For example, as the metal layer, a pure metal or an alloy processed into a sheet shape can be used. For example, as the metal layer, a commercially available metal foil or a metal foil produced by a known method can be used. Regarding a pure metal of Cu, sheets (so-called copper foils) having various thicknesses are commercially available. For example, such a copper foil can be used as the metal layer. The copper foil includes, according to manufacturing methods thereof, an electrolytic copper foil obtained by precipitating a copper foil on a cathode by electroplating and a rolled copper foil obtained by applying heat and pressure to an ingot and stretching the ingot thinly. Any copper foil can be used as the metal layer of the electromagnetic wave shielding material. In addition, for example, regarding Al, sheets (so-called aluminum foils) having various thicknesses are commercially available. For example, such an aluminum foil can be used as the metal layer.

From the viewpoint of reducing the weight of the electromagnetic wave shielding material, one or both (preferably both) of the two metal layers included in the multilayer structure is preferably a metal layer containing a metal selected from the group consisting of Al and Mg. This is because a value (specific gravity/electrical conductivity) obtained by dividing the specific gravity by the electrical conductivity is small both in Al and Mg. As a metal in which this value is smaller is used, the weight of the electromagnetic wave shielding material that exhibits a high shielding ability can be further reduced. As a value calculated from the literature value, for example, a value (specific gravity/electrical conductivity) obtained by dividing the specific gravity by the electrical conductivity of each of Cu, Al, and Mg is as follows. Cu: $1.5 \times 10^{-7}$ m/S, Al: $7.6 \times 10^{-8}$ m/S, Mg: $7.6 \times 10^{-8}$ m/S. From the above values, it can be said that Al and Mg are preferred metals from the viewpoint of reducing the weight of the electromagnetic wave shielding material. The metal layer containing a metal selected from the group consisting of Al and Mg can contain only one of Al and Mg in one form and can contain both in another form. From the viewpoint of reducing the weight of the electromagnetic wave shielding material, one or both (preferably both) of the two metal layers included in the multilayer structure are preferably a metal layer in which the content rate of the metal selected from the group consisting of Al and Mg is 80.0% by mass or more, and still more preferably a metal layer in which the content rate of the metal selected from the group consisting of Al and Mg is 90.0% by mass or more. The metal layer containing at least Al among Al and Mg can be a metal layer in which the Al content rate is 80.0% by mass or more, and it can be a metal layer in which the Al content rate is 90.0% by mass or more. The metal layer containing at least Mg among Al and Mg can be a metal layer in which the Mg content rate is 80.0% by mass or more, and it can be a metal layer in which the Mg content rate is 90.0% by mass or more. The content rate of the metal selected from the group consisting of Al and Mg, the Al content rate, and the Mg content rate can be each, for example, less than 100% by mass or 99.9% by mass or less. The content rate of the metal selected from the group consisting of Al and Mg, the Al content rate, and the Mg content rate are each the content rate with respect to the total mass of the metal layer.

In one form, one or more of the above-described metal layers can be a metal layer having a Cu content rate of 80.0% by mass or more. The Cu content rate of such a layer can be 90.0% by mass or more, and can be 99.9% by mass or less. In addition, in one form, one or more of the above-described metal layers can be a metal layer having an Al content rate of 80.0% by mass or more. The Al content rate of such a layer can be 90.0% by mass or more, and can be less than 100% by mass or 99.9% by mass or less. The Cu content rate and the Al content rate are content rates with respect to the total mass of the metal layer, respectively. In one form, all of the metal layers included in the electromagnetic wave shielding material can be metal layers having a content rate of Cu or Al in the above-described range.

<Specific example of layer configuration>

Specific examples of the layer configuration of the electromagnetic wave shielding material include the following examples.

Example 1: "metal layer / magnetic layer / metal layer"
Example 2: "metal layer / magnetic layer / metal layer / magnetic layer / metal layer"
Example 3: "metal layer / magnetic layer / metal layer / magnetic layer / metal layer / magnetic layer / metal layer"

In an electromagnetic wave shielding material including two or more multilayer structures that includes the magnetic layer between two metal layers, for example, as in Example 2 and Example 3, a metal layer that sandwiches a magnetic layer in a certain multilayer structure can also be a metal layer that sandwiches a magnetic layer in another multilayer structure. In the electromagnetic wave shielding material, the total number of multilayer structures including the magnetic layer between two metal layers can be, for example, 1 to 4. The total number of the multilayer structures is one in Example 1, two in Example 2, and three in Example 3. It is preferable that the total number of the multilayer structures is two or more (for example, two, three, or four) from the viewpoint of further improving the shielding ability of the electromagnetic wave shielding material. In the above, the symbol "/" means that the layer described on the left side of this symbol and the layer described on the right side of this symbol are in direct contact with each other without another layer being interposed therebetween. The total number of the magnetic layers included in the electromagnetic wave shielding material is such that one or more layers are included, two or more layers can be included, and for example, four or less layers can be included. On the other hand, the total number of the metal layers included in the electromagnetic wave shielding material is such that two or more layers are included, and for example, two to five layers can be included.

<Various thicknesses>

From the viewpoint of the workability of the metal layer and the shielding ability of the electromagnetic wave shielding material, the thickness of the metal layer in terms of the thickness per one layer is preferably 4 $\mu$m or more, more preferably 5 $\mu$m or more, still more preferably 10 $\mu$m or more per layer, still more preferably 15 $\mu$m or more, even still more preferably 20 $\mu$m or more, and even still more preferably 25 $\mu$m or more. On the other hand, from the viewpoint of the processability of the metal layer, the thickness of the metal layer in terms of the thickness per one layer is preferably 100 $\mu$m or less, more preferably 50 $\mu$m or less, still more preferably 45 $\mu$m or less, and even still more preferably 40 $\mu$m or less.
In a case where the thickness of one metal layer of the two metal layers that are positioned to sandwich the magnetic layer is denoted as T1, the thickness of the other metal layer is denoted as T2, and T1 is equal to or larger than T2 (that is, T1 = T2 or T1 > T2), the ratio (T2/T1) of the thickness between the two metal layers can be, for example, 0.10 or more, and it is preferably 0.15 or more, more preferably 0.30 or more, still more preferably 0.50 or more, still more preferably 0.70 or more, and even still more preferably 0.80 or more, from the viewpoint that a higher shielding ability can be exhibited with respect to the magnetic field wave. From the viewpoint that a still higher shielding ability can be exhibited with respect to the magnetic field wave, it is preferable that the difference between T1 and T2 is smaller. The thickness ratio (T2/T1) can be 1.00 or less and can also be 1.00 (that is, T1 = T2). In a case where the electromagnetic wave shielding material includes two or more multilayer structures having the magnetic layer between two metal layers, the above description associated with the thickness ratio (T2/T1) can be applied to at least one of the multilayer structures included in the electromagnetic wave shielding material, can be applied to two or more of them, and can be applied to all of them.
The shielding material can be processed by being bent into any shape according to a use application. In a case where the width of the curved portion (hereinafter, referred to as a "curve width") is widened in a case where the shielding material is bent, the shape of the curved portion becomes a gentle curve shape, and it may be difficult to process the shielding material into an intended shape. From this point, the narrower the curve width is, the more preferable it is. The larger the total thickness of the metal layers included in the shielding material is, the wider the curve width tends to be. From the viewpoint of making the curve width of the shielding material narrow, the total thickness of the metal layers included in the electromagnetic wave shielding material is preferably 100 $\mu$m or less, more preferably 90 $\mu$m or less, still more preferably 80 $\mu$m or less, still more preferably 70 $\mu$m or less, even still more preferably 60 $\mu$m or less, even further still more preferably 50 $\mu$m or less, and even further still more preferably 40 $\mu$m or less. The total thickness of the metal layers included in the electromagnetic wave shielding material can be, for example, 8 $\mu$m or more or 10 $\mu$m or more.
Regarding the thickness of the magnetic layer, the thickness per layer can be, for example, 3 $\mu$m or more, where it is preferably 10 $\mu$m or more and more preferably 20 $\mu$m or more, from the viewpoint of the shielding ability of the electromagnetic wave shielding material. In addition, from the viewpoint of processability of the electromagnetic wave shielding material, the thickness of the magnetic layer per layer can be, for example, 90 $\mu$m or less, where it is preferably 70 $\mu$m or less and more preferably 50 $\mu$m or less. In a case where the electromagnetic wave shielding material includes two or more layers of the magnetic layers, the total thickness of the magnetic layers included in the electromagnetic wave shielding material can be, for example, 6 $\mu$m or more and it can be, for example, 180 $\mu$m or less.
In addition, the total thickness of the shielding material can be, for example, 250 $\mu$m or less. From the viewpoint of making the curve width narrow, it is also preferable that the total thickness of the shielding material is small. From this point, the total thickness of the electromagnetic wave shielding material is preferably 200 $\mu$m or less, more preferably 190 $\mu$m or less, and still more preferably 170 $\mu$m or less. The total thickness of the electromagnetic wave shielding material can be, for

example, 30 μm or more or 40 μm or more.

The thickness of each layer included in the electromagnetic wave shielding material shall be determined by imaging a cross section exposed by a known method with a scanning electron microscope (SEM) and determining an arithmetic average of thicknesses of five randomly selected points in the obtained SEM image.

<Manufacturing method for electromagnetic wave shielding material>

(Film forming method for magnetic layer)

The magnetic layer can be produced, for example, by drying a coating layer that is proved by applying a composition for forming a magnetic layer. The composition for forming a magnetic layer contains the components described above and can optionally contain one or more kinds of solvents. Examples of the solvent include various organic solvents, for example, ketone-based solvents such as acetone, methyl ethyl ketone, and cyclohexanone, acetic acid ester-based solvent solvents such as ethyl acetate, butyl acetate, cellosolve acetate, propylene glycol monomethyl ether acetate, and carbitol acetate, carbitols such as cellosolve and butyl carbitol, aromatic hydrocarbon-based solvents such as toluene and xylene, and amide-based solvents such as dimethylformamide, dimethylacetamide, and N-methylpyrrolidone. One kind of solvent or two or more kinds of solvents selected in consideration of the solubility of the component that is used in the preparation of the composition for forming a magnetic layer can be mixed at any ratio and used. The solvent content of the composition for forming a magnetic layer is not particularly limited and may be determined in consideration of the coatability of the composition for forming a magnetic layer.

The composition for forming a magnetic layer can be prepared by sequentially mixing various components in any order or simultaneously mixing them. In addition, as necessary, a dispersion treatment can be carried out using a known dispersing machine such as a ball mill, a bead mill, a sand mill, or a roll mill, and/or a stirring treatment can be also carried out using a known stirrer such as a shaking type stirrer.

The composition for forming a magnetic layer can be applied onto, for example, a support. The coating can be carried out using a known coating device such as a blade coater or a die coater. The coating can be carried out by a so-called roll-to-roll method or a batch method.

Examples of the support onto which the composition for forming a magnetic layer is applied include films of various resins such as polyester such as polyethylene terephthalate (PET) and polyethylene naphthalate (PEN), acryls such as polycarbonate (PC) and polymethyl methacrylate (PMMA), cyclic polyolefin, triacetyl cellulose (TAC), polyether sulfide (PES), polyether ketone, and polyimide. For these resin films, reference can be made to paragraphs 0081 to 0086 of JP2015-187260A. As the support, it is possible to use a support in which a surface (a surface to be coated) onto which the composition for forming a magnetic layer is applied is subjected to a peeling treatment according to a known method. One form of the peeling treatment includes forming a release layer. For the release layer, reference can be made to paragraph 0084 of JP2015-187260A. In addition, a commercially available peeling-treated resin film can also be used as the support. In a case of using a support in which the surface to be coated is subjected to the peeling treatment, it is possible to easily separate the magnetic layer and the support after the film formation.

In one form, it is also possible to directly apply the composition for forming a magnetic layer onto the metal layer using the metal layer as a support. By directly applying the composition for forming a magnetic layer onto the metal layer, the magnetic layer can be directly formed on the metal layer without interposing another layer.

A coating layer formed by applying the composition for forming a magnetic layer can be subjected to a drying treatment according to a known method such as heating or warm air blowing. The drying treatment can be carried out, for example, under conditions in which the solvent contained in the composition for forming a magnetic layer can be volatilized. As an example, the drying treatment can be carried out for 1 minute to 2 hours in a heated atmosphere having an atmospheric temperature of 80°C to 150°C.

Regarding the composition for forming a magnetic layer containing a curing agent in addition to the magnetic particles and the resin, the description described above can be referenced for the curing agent. A magnetic layer formed of such a composition for forming a magnetic layer can be subjected to a curing treatment of a curing agent at any stage. As the curing treatment, a heat treatment or a light irradiation treatment can be carried out according to the kind of the curing agent. For example, in a case where the curing treatment is a heat treatment, such a heat treatment can be carried out before a pressurization treatment described later, in one form, or can be carried out after a pressurization treatment described later, in another form. According to the study by the inventors of the present invention, it was observed that in a case where the heat treatment is carried out after the pressurization treatment, the magnetic permeability of the formed magnetic layer tends to increase. The heat treatment can be carried out, for example, by holding the magnetic layer before the pressurization treatment or after the pressurization treatment in an environment of an atmospheric temperature of 35°C or higher (for example, 35°C or higher and 150°C or lower). The holding time can be, for example, 3 to 72 hours.

The alignment degree of the flat-shaped particle described above can be controlled by a solvent kind, solvent amount, liquid viscosity, coating thickness, and the like of the composition for forming a magnetic layer. For example, in a case where the boiling point of the solvent is low, convection occurs due to drying, and thus the value of the alignment degree tends to be large. In a case where the solvent amount is small, the value of the alignment degree tends to increase due to physical interference between adjacent flat-shaped particles. On the other hand, in a case where the liquid viscosity is low, the rotation of flat-shaped particles is difficult to occur, and thus the value of the alignment degree tends to be small. The value of the alignment degree tends to be small as the coating thickness decreases. In addition, carrying out a pressurization treatment described later can contribute to reducing the value of the alignment degree. In a case of adjusting the various manufacturing conditions described above, the alignment degree of the flat-shaped particles can be controlled within the range described above.

(Pressurization treatment of magnetic layer)

The magnetic layer can also be subjected to a pressurization treatment after film formation. In a case of subjecting the magnetic layer containing the magnetic particles to a pressurization treatment, it is possible to increase the density of the magnetic particles in the magnetic layer, and it is possible to obtain a higher magnetic permeability. In addition, in the magnetic layer containing the flat-shaped particles, it is possible to reduce the value of the alignment degree by the pressurization treatment, and it is possible to obtain a higher magnetic permeability.

The pressurization treatment can be carried out by applying pressure in the thickness direction of the magnetic layer using a plate-shape pressing machine, a roll pressing machine, or the like. In the plate-shape pressing machine, an object to be pressurized can be disposed between two flat press plates that are disposed vertically, and the two press plates can be put together by mechanical or hydraulic pressure to apply pressure to the object to be pressurized. In the roll pressing machine, an object to be pressurized is allowed to pass between the rotating pressurization rolls that are disposed vertically, and at that time, mechanical or hydraulic pressure is applied to the pressurization rolls, or the distance between the pressurization rolls is made to be smaller than the thickness of the object to be pressurized, whereby the pressure can be applied.

The pressure during the pressurization treatment can be set freely. For example, in a case of a plate-shape pressing machine, it is, for example, 1 to 50 newtons (N)/mm$^2$. In a case of a roll pressing machine, it is, for example, 20 to 400 N/mm in terms of the linear pressure.

The pressurization time can be set freely. It takes, for example, 5 seconds to 4 hours in a case where a plate-shape pressing machine is used. In a case where a roll pressing machine is used, the pressurization time can be controlled by the transport speed of the object to be pressurized, where the transport speed is, for example, 10 cm/min to 200 m/min.

The materials of the press plate and the pressurization roll can be randomly selected from metal, ceramics, plastic, and rubber.

In the pressurization treatment, it is also possible to carry out a heating and pressurization treatment, for example, by applying a temperature to both of upper and lower press plates of a plate-shape pressing machine or one press plate thereof, or one roll of upper and lower rolls of a roll pressing machine. In the heating and pressurization treatment, the magnetic layer can be softened by heating, which makes it possible to obtain a high compression effect in a case where pressure is applied. The temperature at the time of heating can be set freely, and it is, for example, 50°C or higher and 200°C or lower. The temperature at the time of heating can be the internal temperature of the press plate or the roll. Such a temperature can be measured with a thermometer installed inside the press plate or the roll. In one form, a heat treatment can be carried out as a curing treatment of a curing agent before or after the heating and pressurization treatment. Such a heat treatment is as described above.

After the heating and pressurization treatment with the plate-shape pressing machine, the press plates can be spaced apart from each other, for example, in a state where the temperature of the press plates is high, whereby the magnetic layer can be taken out. Alternatively, the press plate can be cooled by a method such as water cooling or air cooling while maintaining the pressure, and then the press plates can be spaced apart to take out the magnetic layer.

In the roll pressing machine, the magnetic layer can be cooled immediately after pressing, by a method such as water cooling or air cooling.

It is also possible to repeat the pressurization treatment two or more times.

In a case where the magnetic layer is formed into a film on a release film, it is possible to carry out a pressurization treatment, for example, in a state where the magnetic layer is laminated on the release film. Alternatively, the magnetic layer can also be peeled off from the release film and can be subjected to a pressurization treatment as a single layer of the magnetic layer.

(Bonding of metal layer and magnetic layer)

The adjacent metal layer and magnetic layer can be directly bonded to each other without interposing another layer, for example, by applying pressure and heat to carry out crimping. A plate-shape pressing machine, a roll pressing machine, or the like can be used for the crimping. In the crimping step, the magnetic layer is softened, and the contact with the surface of the metal layer is promoted, whereby the two layers adjacent to each other can be adhered to each other. The pressure at the time of crimping can be set freely. It is, for example, 1 to 50 N/mm$^2$ in a case of a plate-shape pressing machine. In a case of a roll pressing machine, it is, for example, 20 to 400 N/mm in terms of the linear pressure. The pressurization time at the time of crimping can be set freely. It takes, for example, 5 seconds to 30 minutes in a case where a plate-shape pressing machine is used. In a case where a roll pressing machine is used, the pressurization time can be controlled by a transport speed of an object to be pressurized, and the transport speed is, for example, 10 cm/min to 200 m/min. The temperature during the crimping can be randomly selected, and is, for example, 50°C or higher and 200°C or lower. The temperature during the above-described crimping can be, for example, an internal temperature of a press plate or a roll.

In the multilayer structure of the electromagnetic wave shielding material, the metal layer is in direct contact with the adjacent magnetic layer. As described above, it is preferable that the two layers are bonded to each other without interposing another layer, since the process is simple as compared with a method of bonding the two layers to each other by interposing another layer such as an adhesive layer or a pressure-sensitive adhesive layer. On the other hand, in the bonding without interposing a layer for increasing the adhesiveness between the layers such as the adhesive layer and the pressure-sensitive adhesive layer, peeling between the layers tends to occur easily. On the other hand, in the electromagnetic wave shielding material, the magnetic layer in direct contact with the metal layer contains the urethane bond-containing resin at the above-described content. The inventors of the present invention consider that this contributes to making it possible to enhance the adhesiveness between the metal layer and the magnetic layer without interposing another layer. It is presumed that this is due to that the urethane bond-containing resin contains a high-polarity moiety. However, the present invention is not limited to such supposition.

The electromagnetic wave shielding material can have any shape such as a film shape (also referred to as a sheet shape) and any size. For example, a film-shaped electromagnetic wave shielding material can be bent into any shape and incorporated into an electronic component or an electronic apparatus.

[Electronic component]

One aspect of the present invention relates to an electronic component including the electromagnetic wave shielding material. Examples of the electronic component include an electronic component included in an electronic apparatus such as a mobile phone, a mobile information terminal, and a medical device, and various electronic components such as a semiconductor element, a capacitor, a coil, and a cable. The electromagnetic wave shielding material can be bent into any shape, for example, according to the shape of the electronic component, thereby capable of being disposed in the inside of the electronic component or capable of being disposed as a cover material that covers the outside of the electronic component. Alternatively, it can be processed into a tubular shape and disposed as a cover material that covers the outside of the cable.

[Electronic apparatus]

One aspect of the present invention relates to an electronic apparatus including the electromagnetic wave shielding material. Examples of the electronic apparatus include electronic apparatuses such as a mobile phone, a mobile information terminal, and a medical device, electronic apparatuses including various electronic components such as a semiconductor element, a capacitor, a coil, and a cable, and electronic apparatuses in which electronic components are mounted on a circuit board. Such an electronic apparatus can include the electromagnetic wave shielding material as a constitutional member of an electronic component included in the device. In addition, as a constitutional member of the electronic apparatus, the electromagnetic wave shielding material can be disposed in the inside of the electronic apparatus or can be disposed as a cover material that covers the outside of the electronic apparatus. Alternatively, it can be processed into a tubular shape and disposed as a cover material that covers the outside of the cable.

Examples of the usage form of the electromagnetic wave shielding material include a usage form in which a semiconductor package on a printed board is coated with a shielding material. For example, "Electromagnetic wave shielding technology in a semiconductor package" (Toshiba Review Vol. 67, No. 2 (2012) P. 8) discloses a method of obtaining a high shielding effect by electrically connecting a side via of an end part of a package substrate and an inner surface of a shielding material in a case where a semiconductor package is coated with a shielding material, thereby carrying out ground wiring. In order to carry out such wiring, it is desirable that the outermost layer of the shielding material on the electronic component side is a metal layer. In one form, since one or both outermost layers of the shielding material can be a metal layer in the electromagnetic wave shielding material, the electromagnetic wave shielding material can be suitably used in a case of carrying out the wiring as described above.

[Examples]

Hereinafter, the present invention will be described in more detail with reference to Examples. However, the present invention is not limited to the embodiments shown in Examples.

[Urethane bond-containing resin of magnetic layer]

The urethane bond-containing resin of the magnetic layer shown in Table 1 is the following resin. In Table 1, the polyurethane resin is denoted as "polyurethane", and the polyester urethane resin is denoted as "polyester urethane".

The polyurethane resin having a glass transition temperature Tg of -50°C is NIPPOLLAN 5120 (manufactured by Tosoh Corporation).

The polyester urethane resin having a glass transition temperature Tg of -30°C is UR-6100 manufactured by TOYOBO Co., Ltd.

The polyester urethane resin having a glass transition temperature Tg of -3°C is UR-3200 manufactured by TOYOBO Co., Ltd.

The polyester urethane resin having a glass transition temperature Tg of 23°C is UR-8300 manufactured by TOYOBO Co., Ltd.

The glass transition temperature of the urethane bond-containing resin shown in Table 1 is a value obtained by the following method.

The same resin (a pellet-shaped or powder-shaped specimen) as the resin used in the preparation of the composition for forming a magnetic layer (the coating liquid) was placed in a specimen pan made of aluminum and sealed with a pressing machine, and the heat flow was measured under the following conditions using Q100 manufactured by TA Instruments as a differential scanning calorimeter. From the measurement results, the glass transition temperature of the resin was determined as the baseline shift start temperature in the heat flowchart at the time of temperature rise.

(Measurement conditions)

Scanning temperature: -80.0°C to 200.0°C
Temperature rising rate: 10.0 °C/min

[Example 1]

<Preparation of composition for forming magnetic layer (coating liquid)>

To a plastic bottle, the following substances were added and mixed with a shaking type stirrer for 12 hours to prepare a coating liquid;

Fe-Si-Al flat-shaped magnetic particles (Sendust MFS-SUH manufactured by MKT): 12 g,
Polyester urethane resin (UR-6100 manufactured by Toyobo Co., Ltd., concentration of solid contents: 45% by mass): 6.7 g
polyfunctional isocyanate (TAKENATE D101E, manufactured by Mitsui Chemicals, Inc., concentration of solid contents: 75% by mass): 0.1 g, and
cyclohexanone: 25 g.

The content of the polyester urethane resin is the value shown in Table 1, with respect to 100 parts by mass of the total mass of the magnetic layer formed of the prepared composition for forming a magnetic layer.

<Production of magnetic layer>

(Formation of film of magnetic layer)

A coating liquid was applied onto a peeling surface of a peeling-treated PET film (PET75-JOL manufactured by NIPPA Co., Ltd.) with a blade coater having a coating gap of 300 μm and dried for 30 minutes in a drying device having an internal atmospheric temperature of 80°C to form a film of a film-shaped magnetic layer on the peeling-treated PET film.

(Pressurization treatment and heat treatment of magnetic layer)

Upper and lower press plates of a plate-shape pressing machine (Mini Test Press, manufactured by Toyo Seiki Seisaku-sho, Ltd.) were heated to 140°C (internal temperature of press plate), and a magnetic layer obtained by peeling off the peeling-treated PET film was sandwiched between two sheets of Teflon (registered trademark) having a thickness of 1 mm and held for 10 minutes in a state where a pressure of 30 N/mm$^2$ was applied. The upper and lower press plates were cooled to 50°C (the internal temperature of the press plates) while maintaining the pressure, and then the magnetic layer was taken out from between the two Teflon (registered trademark) sheets.

Then, in order to carry out a crosslinking reaction between a polyester urethane resin contained in the magnetic layer, and a polyfunctional isocyanate to a crosslinking reaction, the magnetic layer was held for 48 hours in a drying device having an internal atmospheric temperature of 60°C and subjected to a heat treatment to obtain a magnetic layer. A measurement sample for various evaluations described later was cut out from a part of the obtained magnetic layer.

<Production of shielding material>

Using the magnetic layer obtained above as the magnetic layer and using a copper foil (JIS H3100: 2018 standard, alloy number C1020R-H, Cu content rate of 99.9% by mass or more) having a thickness of 20 μm as the metal layer, five layers of "copper foil (metal layer)/magnetic layer/copper foil (metal layer)/magnetic layer/copper foil (metal layer)" were laminated to produce a laminate, without interposing other layers between two layers adjacent to each other.

Upper and lower press plates of a plate-shape pressing machine (a large-scale hot press TA-200-1W manufactured by YAMAMOTO ENG. WORKS Co., LTD.) were heated to 140°C (the internal temperature of the press plate), and the laminate was installed in the center of the press plate and held for 10 minutes in a state where a pressure of 4.66 N/mm$^2$ was applied, whereby the copper foil and the magnetic layer were subjected to the thermal crimping. The upper and lower press plates were cooled to 50°C (the internal temperature of the press plates) while maintaining the pressure, and then the laminate was taken out from the plate-shape pressing machine.

In this way, an electromagnetic wave shielding material of Example 1 was obtained. The shielding material of Example 1 had a multilayer structure of "copper foil (metal layer)/magnetic layer/copper foil (metal layer)" twice.

<Measurement of magnetic permeability>

A measurement sample having a size of 28 mm × 10 mm was cut out from the magnetic layer, the magnetic permeability, and the magnetic permeability was measured using a magnetic permeability measuring apparatus (per01 manufactured by KEYCOM Corporation), and the magnetic permeability was determined as the real part (μ') of the complex specific magnetic permeability at a frequency of 3 MHz (measurement temperature: 25°C). The evaluation results obtained by evaluating the magnetic permeability obtained in this way according to the following evaluation standards are shown in Table 1.

A: The magnetic permeability μ' is 100 or more.
B: The magnetic permeability μ' is 40 or more and less than 100.
C: The magnetic permeability μ' is less than 40.

<Measurement of electrical conductivity>

A cylindrical main electrode having a diameter of 30 mm was connected to the negative electrode side of a digital super-insulation resistance meter (TR-811A manufactured by Takeda RIKEN Industries), a ring electrode having an inner diameter of 40 mm and an outer diameter of 50 mm was connected to the positive electrode side thereof, the main electrode was installed on a sample piece of the magnetic layer cut to a size 60 mm × 60 mm, the ring electrode was installed at a position surrounding the main electrode, a voltage of 25 V was applied to both electrodes, and the surface electrical resistivity of the magnetic layer alone was measured. The electrical conductivity of the magnetic layer was calculated from the surface electrical resistivity and the following expression. The calculated electrical conductivity was 1.1 × 10$^{-2}$ S/m.

As the thickness, the thickness of the magnetic layer, which had been determined according to the following method, was used.

$$\text{Electrical conductivity [S/m]} = 1/(\text{surface electrical resistivity } [\Omega] \times \text{thickness [m]})$$

<Acquisition of cross-sectional image of shielding material>

Cross-section processing was carried out to expose the cross-section of the shielding material by the following method.

A shielding material cut out to a size of 3 mm × 3 mm was embedded in a resin, and a cross section of the shielding material was cut with an ion milling device (IM4000PLUS manufactured by Hitachi High-Tech Corporation).

The cross-section of the shielding material, which had been exposed in this way, was observed with a scanning electron microscope (SU8220, manufactured by Hitachi High-Tech Corporation) under the conditions of an acceleration voltage of 2 kV and a magnification of 100 times to obtain a backscattered electron image. From the obtained image, the thickness of each of the two magnetic layers, the thickness of each of the three metal layers, and the total thickness of the shielding material were measured at five positions, respectively, with the scale bar as a reference. The arithmetic average of the respective thicknesses was defined as the thickness of each magnetic layer, the thickness of each metal layer, and the total thickness of the shielding material. The thickness of each magnetic layer was 30 $\mu$m, the thickness of each metal layer was 20 $\mu$m, and the total thickness of the shielding material was 120 $\mu$m.

<Acquisition of cross-sectional image of magnetic layer>

In a cross section of the shielding material of Example 1, which had been exposed by the cross-section processing in the same manner as described above, a portion of the magnetic layer was observed with a scanning electron microscope (SU8220, manufactured by Hitachi High-Tech Corporation) under the conditions of an acceleration voltage of 2 kV and a magnification of 1,000 times, thereby obtaining a backscattered electron image.

<Measurement of aspect ratio of magnetic particle and alignment degree of flat-shaped particle>

Using the backscattered electron image acquired as above, the aspect ratio of the magnetic particles was determined according to the method described above, and the flat-shaped particles were specified from the value of the aspect ratio. As a result of determining, as described above, whether or not the magnetic layer contained flat-shaped particles as the magnetic particles, it was determined that the magnetic layer contains flat-shaped particles. Further, as a result of determining the alignment degree of the magnetic particles specified as the flat-shaped particles, according to the method described above, the alignment degree was 13°. In addition, an average value (arithmetic average) of the aspect ratios of all the particles specified as the flat-shaped particles was determined as the aspect ratio of the flat-shaped particles contained in the magnetic layer. The determined aspect ratio was 0.071.

<Evaluation of shielding ability (KEC method)>

A shielding material cut to a size of 150 mm × 150 mm was installed between antennas of a KEC method evaluation device including a signal generator, an amplifier, a pair of magnetic field antennas, and a spectrum analyzer, and at a frequency of 100 kHz, a ratio of the intensity of the received signal in a case where the shielding material was not present to the intensity of the received signal in a case where the shielding material was present was determined and denoted as the shielding ability. The operation was carried out for the magnetic field antenna to obtain the electromagnetic wave shielding ability (magnetic field wave shielding ability). It is noted that KEC is an abbreviation for Kansai Electronic Industry Development Center. From the obtained values, the evaluation results of the shielding ability evaluated according to the following evaluation standards are shown in Table 1.

(Evaluation standards)

A: 30 dB or more
B: 25 dB or more and less than 30 dB
C: less than 25 dB

<Peel strength>

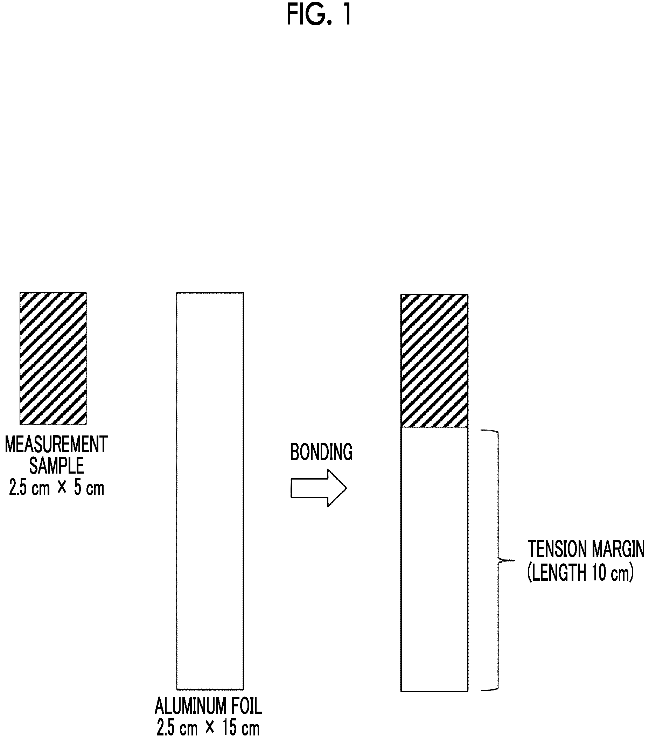

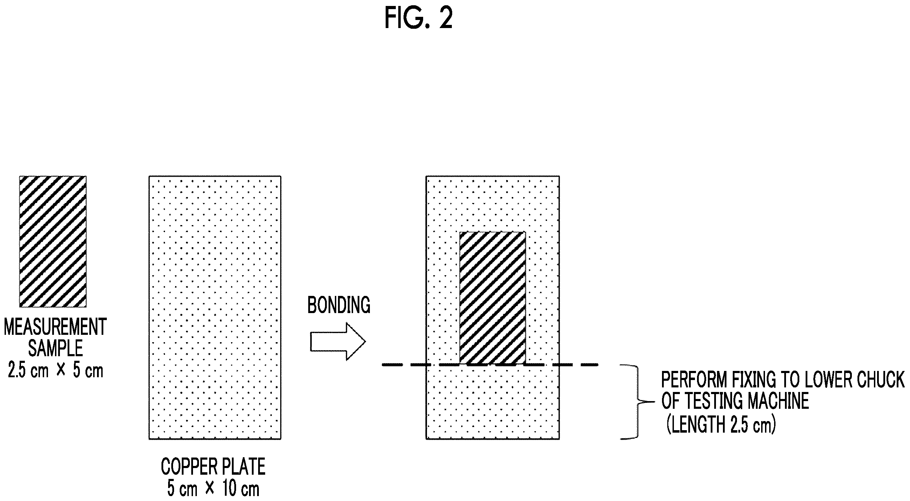

Figs.1 and 2 are explanatory views related to a measurement of peel strength.

The peel strength of the electromagnetic wave shielding material of Example 1 was measured by the following method.

A measurement sample having a short side length of 2.5 cm and a long side length of 5 cm was cut out from the electromagnetic wave shielding material of Example 1.

An aluminum foil (manufactured by TAKEUCHI METAL FOIL & POWDER Co., LTD., model number: A1N30H-O, thickness: 50 μm) having a short side length of 2.5 cm and a long side length of 15 cm was prepared.

The metal layer (copper foil) of one outermost layer of the measurement sample and the aluminum foil were bonded to each other using a cyanoacrylate adhesive such that one short side of each of foils overlaps one another, thereby producing a tension margin. Such a tension margin is a portion of the aluminum foil, which has a length of 10 cm to which the measurement sample is not bonded (see Fig. 1).

Thereafter, a metal foil (copper foil) and a copper plate (manufactured by Hikari Co., Ltd., size: thickness of 1 mm, short side length of 5 cm, long side length of 10 cm) of the other outermost layer of the measurement sample (that is, the side on which the tension margin was not produced) were bonded using double-sided tape (see Fig. 2) by disposing the measurement sample on the center portion of the copper plate.

A portion of the copper plate to which the electromagnetic wave shielding material was not attached was fixed to a lower chuck of a testing machine (see Fig. 2).

Thereafter, the tension margin was folded at 180° and fixed to an upper chuck of the testing machine, and a peel test was performed under the following measurement conditions. Table 1 shows the peel strength calculated by dividing the load (unit: N (Newton)) obtained as a measured value by the short side length (2.5 cm).

The peel strength measured by the above-described method can be said to be an indicator of an adhesive force between two layers adjacent to each other in the laminate, and it can be said that the higher the value of the peel strength measured by the above-described method, the higher the adhesive force between the adjacent metal layer and the magnetic layer in the electromagnetic wave shielding material. From the viewpoint of high adhesiveness between the adjacent metal layer and the magnetic layer, the peel strength measured by the above method is preferably more than 0.5 N/cm, more preferably 0.6 N/cm or more, still more preferably 1.0 N/cm or more, even more preferably 1.5 N/cm or more, and further more preferably 2.0 N/cm or more. Such peel strength can be, for example, 7.0 N/cm or less, 6.5 N/cm or less, 6.0 N/cm or less, 5.5 N/cm or less, or 5.0 N/cm or less.

(Measurement conditions)

Testing machine: a universal material testing instrument TENSILON (RTF-1310) manufactured by A&D Company, Limited

Measurement environment: temperature of 23°C, relative humidity of 50%
Load cell: 500 newtons (N)
Tensile rate: 30 mm/min

<Evaluation of durability (drop peeling test)>

The electromagnetic wave shielding material of Example 1 was subjected to a drop peel test according to the Du Pont method described in JIS-K-5600-5-3: 1999. A drop test was performed 5 times at a height of 200 mm under the conditions of a radius of 6.35 mm for the mold and the support and a mass of 300 g for the weight, and the evaluation was performed according to the following standards. The expression "the drop test was carried out five times" means that the drop test was carried out once for each of five measurement samples cut out from the electromagnetic wave shielding material of Example 1 (and thus the number of times of the test was a total of five times).

A: No peeling was observed in all of the five tests.
B: peeling was observed at least once between the adjacent metal layer and the magnetic layer in the five tests.
C: In the 5 tests, peeling was observed between the adjacent metal layer and the magnetic layer in all of the 5 tests.

[Examples 2 to 6, Examples 9 and 10, Comparative Examples 1 and 2]

An electromagnetic wave shielding material was produced and various evaluations were performed according to the method described for Example 1, except that the items shown in Table 1 were changed as shown in Table 1.

As a result of measuring the various thicknesses by the method described above for each of Examples and Comparative Examples, the thickness of each magnetic layer, the thickness of each copper foil (metal layer), and the total thickness of the shielding material were the same as the values obtained for Example 1.

[Example 7]

An electromagnetic wave shielding material was produced and various evaluations were performed according to the method described in Example 1, except that an aluminum foil (in accordance with JIS H 4160: 2006 standard, alloy number: 1N30, classification (1) O, AI content rate: 99.3% by mass or more) having a thickness of 30 μm was used as the metal layer instead of the copper foil.

In this way, an electromagnetic wave shielding material of Example 7 was obtained. The shielding material of Example 7 had a multilayer structure of "aluminum foil (metal layer)/magnetic layer/aluminum foil (metal layer)" twice.

In Example 7, as a result of measuring the various thicknesses according to the method described above, the thickness of each magnetic layer was 30 μm, the thickness of each metal layer was 30 μm, and the total thickness of the shielding material was 150 μm.

[Example 8]

Three layers of "copper foil (metal layer)/magnetic layer/copper foil (metal layer)" were superposed without interposing other layers between two adjacent layers to produce a laminate.

Upper and lower press plates of a plate-shape pressing machine (a large-scale hot press TA-200-1W manufactured by YAMAMOTO ENG. WORKS Co., LTD.) were heated to 140°C (the internal temperature of the press plate), and the laminate was installed in the center of the press plate and held for 10 minutes in a state where a pressure of 4.66 N/mm$^2$ was applied, whereby the copper foil and the magnetic layer were subjected to the thermal crimping. The upper and lower press plates were cooled to 50°C (the internal temperature of the press plates) while maintaining the pressure, and then the laminate was taken out from the plate-shape pressing machine.

In this way, an electromagnetic wave shielding material of Example 8 was obtained. The shielding material of Example 8 had a multilayer structure of "copper foil (metal layer)/magnetic layer/copper foil (metal layer)" once. In Example 8, various evaluations were performed by the method described for Example 1.

In Example 8, the thicknesses of the magnetic layer and each copper foil (metal layer) were the same as the values obtained in Example 1, and the total thickness of the shielding material was 70 μm, as a result of measuring the various thicknesses by the method described above.

[Example 11]

An electromagnetic wave shielding material was produced and various evaluations were carried out according to the method described for Example 1, except that a composition for forming a magnetic layer was prepared according to the method described below. In Table 1, the following epoxy resins are denoted as "epoxy".

<Preparation of composition for forming magnetic layer (coating liquid)>

To a plastic bottle, the following substances were added and mixed with a shaking type stirrer for 12 hours to prepare a coating liquid;

Fe-Si-AI flat-shaped magnetic particles (Sendust MFS-SUH manufactured by MKT): 12 g,
a polyurethane resin (NIPPOLLAN 5120, manufactured by Tosoh Corporation, concentration of solid contents: 30% by mass): 7.0 g,
polyfunctional isocyanate (TAKENATE D101E, manufactured by Mitsui Chemicals, Inc., concentration of solid contents: 75% by mass): 0.42 g,
Epoxy resin (HP-A-4860 manufactured by DIC Corporation, concentration of solid contents: 100% by mass): 0.8 g
Epoxy curing catalyst (IBMI12 manufactured by Mitsubishi Chemical Corporation., concentration of solid contents: 100% by mass): 0.02 g
cyclohexanone: 20 g

The content of the polyurethane resin and the content of the epoxy resin are the values shown in Table 1, with respect to 100 parts by mass of the total mass of the magnetic layer formed of the prepared composition for forming a magnetic layer.

[Comparative Example 3]

Production of an electromagnetic wave shielding material was attempted according to the method described for Example 1, except that a composition for forming a magnetic layer was prepared according to the method described below. However, since the magnetic layer after applying the composition for forming a magnetic layer and drying the composition had poor self-supporting properties and could not form a film of the magnetic layer, an electromagnetic wave shielding material could not be produced.

<Preparation of composition for forming magnetic layer (coating liquid)>

To a plastic bottle, the following substances were added and mixed with a shaking type stirrer for 12 hours to prepare a coating liquid;

Fe-Si-Al flat-shaped magnetic particles (Sendust MFS-SUH manufactured by MKT): 12 g,
Epoxy resin (HP-A-4860 manufactured by DIC Corporation, concentration of solid contents: 75% by mass): 4 g
Epoxy curing catalyst (IBMI12 manufactured by Mitsubishi Chemical Corporation., concentration of solid contents: 100% by mass): 0.1 g
cyclohexanone: 25 g.

The content of the epoxy resin is the value shown in Table 1, with respect to 100 parts by mass of the total mass of the magnetic layer formed of the prepared composition for forming a magnetic layer.
The above results are shown in Table 1. In Table 1, the copper foil is abbreviated as "Cu", the aluminum foil is abbreviated as "Al", and the magnetic layer is abbreviated as "Mag".

[Table 1]

| | | Composition of magnetic layer | | | | | Electromagnetic wave shielding material | | | |
|---|---|---|---|---|---|---|---|---|---|---|
| | Resin | Content of urethane bond-containing resin/with respect to total mass of magnetic layer (parts by mass) | Urethane bond-containing resin Tg (°C) | Content of polyfunctional isocyanate/with respect to content of urethane bond-containing resin (parts by mass) | Content of epoxy resin/ with respect to total mass of magnetic layer (parts by mass) | Magnetic permeability μ' | Configuration | Peel strength (N/cm) | Shielding ability | Drop peeling test |
| Example 1 | Polyester urethane | 20 | -30 | 2.5 | - | A | Cu/Mag/Cu/Mag/Cu | 3.0 | A | A |
| Example 2 | Polyurethane | 17 | -50 | 15 | - | A | Cu/Mag/Cu/Mag/Cu | 3.6 | A | A |
| Example 3 | Polyester urethane | 15 | -30 | 2.5 | - | A | Cu/Mag/Cu/Mag/Cu | 2.4 | A | A |
| Example 4 | Polyester urethane | 23 | -30 | 2.5 | - | A | Cu/Mag/Cu/Mag/Cu | 4.2 | A | A |
| Example 5 | Polyester urethane | 13 | -30 | 2.5 | - | A | Cu/Mag/Cu/Mag/Cu | 1.8 | A | B |
| Example 6 | Polyester urethane | 29 | -30 | 2.5 | - | B | Cu/Mag/Cu/Mag/Cu | 5.0 | B | A |
| Example 7 | Polyester urethane | 20 | -30 | 2.5 | - | A | Al/Mag/Al/Mag/Al | 3.0 | A | A |
| Example 8 | Polyester urethane | 20 | -30 | 2.5 | - | A | Cu/Mag/Cu | 3.0 | B | A |
| Example 9 | Polyester urethane | 17 | -3 | 15 | - | A | Cu/Mag/Cu/Mag/Cu | 3.1 | A | A |
| Example 10 | Polyester urethane | 17 | 23 | 15 | - | A | Cu/Mag/Cu/Mag/Cu | 3.2 | A | A |
| Example 11 | Polyurethane/Epoxy | 14 | -50 | 15 | 4 | A | Cu/Mag/Cu/Mag/Cu | 4.1 | A | A |
| Comparative Example 1 | Polyester urethane | 4 | -30 | 2.5 | - | A | Cu/Mag/Cu/Mag/Cu | 0.4 | A | C |
| Comparative Example 2 | Polyester urethane | 31 | -30 | 2.5 | - | C | Cu/Mag/Cu/Mag/Cu | 8.1 | C | A |
| Comparative Example 3 | Epoxy | - | - | - | 20 | Film of magnetic layer cannot be formed | | | | |

For Examples 2, 9, and 10 in which the glass transition temperature Tg of the resin contained in the magnetic layer was different, an electromagnetic wave shielding material having a size of 5 cm × 5 cm was produced by the method described for each example.

The produced electromagnetic wave shielding material was manually bent in half and then spread out to be flat, and this was repeated for each electromagnetic wave shielding material 5 times. As a result, in Examples 2 and 9, breakage was not observed in the electromagnetic wave shielding material, whereas in Example 10, breakage was observed in the electromagnetic wave shielding material.

[Industrial Applicability]

One aspect of the present invention is useful in the technical fields of various electronic components and various electronic apparatuses.

**Claims**

1. An electromagnetic wave shielding material comprising:

   a magnetic layer containing magnetic particles and a resin, between two metal layers,
   wherein the magnetic layer is in direct contact with each of the two metal layers, and
   the magnetic layer contains 13 parts by mass or more and less than 30 parts by mass of a urethane bond-containing resin with respect to 100 parts by mass of a total mass of the magnetic layer.

2. The electromagnetic wave shielding material according to claim 1,
   wherein the magnetic layer contains 15 parts by mass or more and 23 parts by mass or less of a urethane bond-containing resin with respect to 100 parts by mass of the total mass of the magnetic layer.

3. The electromagnetic wave shielding material according to claim 1,
   wherein a glass transition temperature of the urethane bond-containing resin is -60°C or higher and lower than 0°C.

4. The electromagnetic wave shielding material according to claim 1,
   wherein the magnetic layer further contains an epoxy resin.

5. The electromagnetic wave shielding material according to claim 4,
   wherein a total content of the urethane bond-containing resin and an epoxy group-containing resin in the magnetic layer is 15 parts by mass or more and 20 parts by mass or less with respect to 100 parts by mass of the total mass of the magnetic layer.

6. The electromagnetic wave shielding material according to claim 1,

   wherein two or more multilayer structures in which the magnetic layer is provided between the two metal layers are included, and
   the magnetic layer is in direct contact with each of the two metal layers in each multilayer structure.

7. The electromagnetic wave shielding material according to claim 1,
   wherein one or more of the metal layers are metal layers having a Cu content rate of 80.0% by mass or more.

8. The electromagnetic wave shielding material according to claim 1,
   wherein one or more of the metal layers are metal layers having an Al content rate of 80.0% by mass or more.

9. The electromagnetic wave shielding material according to claim 1,

   wherein the magnetic layer contains 15 parts by mass or more and 23 parts by mass or less of a urethane bond-containing resin with respect to 100 parts by mass of the total mass of the magnetic layer,
   a glass transition temperature of the urethane bond-containing resin is -60°C or higher and lower than 0°C,
   the electromagnetic wave shielding material includes two or more multilayer structures in which the magnetic layer is provided between the two metal layers, and the magnetic layer is in direct contact with each of the two metal layers in each multilayer structure, and

one or more metal layers are metal layers having a Cu content rate of 80.0% by mass or more.

10. The electromagnetic wave shielding material according to claim 1,

wherein the magnetic layer contains 15 parts by mass or more and 23 parts by mass or less of a urethane bond-containing resin with respect to 100 parts by mass of the total mass of the magnetic layer,
a glass transition temperature of the urethane bond-containing resin is -60°C or higher and lower than 0°C,
the electromagnetic wave shielding material includes two or more multilayer structures in which the magnetic layer is provided between the two metal layers, and the magnetic layer is in direct contact with each of the two metal layers in each multilayer structure, and
one or more metal layers are metal layers having an Al content rate of 80.0% by mass or more.

11. The electromagnetic wave shielding material according to claim 1,

wherein the magnetic layer further contains an epoxy group-containing resin,
a total content of the urethane bond-containing resin and the epoxy group-containing resin in the magnetic layer is 15 parts by mass or more and 20 parts by mass or less with respect to 100 parts by mass of the total mass of the magnetic layer,
a glass transition temperature of the urethane bond-containing resin is -60°C or higher and lower than 0°C,
the electromagnetic wave shielding material includes two or more multilayer structures in which the magnetic layer is provided between the two metal layers, and the magnetic layer is in direct contact with each of the two metal layers in each multilayer structure, and
one or more of the metal layers are metal layers having a Cu content rate of 80.0% by mass or more.

12. An electronic component comprising:
the electromagnetic wave shielding material according to any one of claims 1 to 11.

13. An electronic apparatus comprising:
the electromagnetic wave shielding material according to any one of claims 1 to 11.

# FIG. 1

MEASUREMENT
SAMPLE
2.5 cm × 5 cm

ALUMINUM FOIL
2.5 cm × 15 cm

BONDING

TENSION MARGIN
(LENGTH 10 cm)

# FIG. 2

MEASUREMENT
SAMPLE
2.5 cm × 5 cm

COPPER PLATE
5 cm × 10 cm

BONDING

PERFORM FIXING TO LOWER CHUCK
OF TESTING MACHINE
(LENGTH 2.5 cm)

EP 4 550 960 A1

## INTERNATIONAL SEARCH REPORT

| International application No. |
| --- |
| **PCT/JP2023/023447** |

**A. CLASSIFICATION OF SUBJECT MATTER**

*H05K 9/00*(2006.01)i; *B32B 7/027*(2019.01)i; *B32B 15/08*(2006.01)i; *B32B 15/20*(2006.01)i; *B32B 27/18*(2006.01)i; *B32B 27/40*(2006.01)i; *H01B 5/14*(2006.01)i; *H01F 1/26*(2006.01)i

FI: H05K9/00 W; H01F1/26; B32B15/08 N; B32B27/18 H; B32B27/40; B32B7/027; B32B15/20; H01B5/14 Z; B32B15/08 Q; H05K9/00 Q

According to International Patent Classification (IPC) or to both national classification and IPC

**B. FIELDS SEARCHED**

Minimum documentation searched (classification system followed by classification symbols)

H05K9/00; B32B7/027; B32B15/08; B32B15/20; B32B27/18; B32B27/40; H01B5/14; H01F1/26

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 2021-28940 A (TOYO INK SC HOLDINGS CO LTD) 25 February 2021 (2021-02-25) paragraphs [0002], [0014], [0027], [0037], [0038], [0044], [0045], [0060], [0077], fig. 2 | 1-13 |

☐ Further documents are listed in the continuation of Box C.  ☑ See patent family annex.

| | |
| --- | --- |
| * Special categories of cited documents: <br> "A" document defining the general state of the art which is not considered to be of particular relevance <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
| --- | --- |
| **08 September 2023** | **19 September 2023** |

| Name and mailing address of the ISA/JP | Authorized officer |
| --- | --- |
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (January 2015)

## INTERNATIONAL SEARCH REPORT
### Information on patent family members

International application No.

**PCT/JP2023/023447**

| Patent document cited in search report | Publication date (day/month/year) | Patent family member(s) | Publication date (day/month/year) |
|---|---|---|---|
| JP 2021-28940 A | 25 February 2021 | (Family: none) | |

Form PCT/ISA/210 (patent family annex) (January 2015)

**REFERENCES CITED IN THE DESCRIPTION**

**Patent documents cited in the description**

- JP 2019153623 A
- JP 2018131640 A
- JP 2015187260 A

**Non-patent literature cited in the description**

- *Toshiba Review*, 2012, vol. 67 (2), 8